# EUROPEAN PATENT APPLICATION

(11) **EP 1 003 272 A2**
(43) Date of publication of application: **24.05.2000**
(21) Application number: 99308724.6
(22) Date of filing: 03.11.1999
(51) Int. Cl.: H02M 3/00

(54) **Switching circuit**

(30) Priority: 17.11.1998 JP 32658898
(71) Applicant: FUJI ELECTRIC CO. LTD., Kawasaki 210 (JP)
(72) Inventor: Igarashi, Seiki, c/o Fuji Electric Co., Ltd, Kawasaki 210 (JP); Fujihira, Tatsuhiko, c/o Fuji Electric Co., Ltd., Kawasaki 210 (JP)
(74) Representative: Bridge-Butler, Alan James

(57) **Abstract**

A switching circuit is constructed in such a manner that a condenser is connected in parallel to a switching element such as a MOSFET to perform a resonance operation with an inductance. A super-junction MOSFET with a small ON resistance and a large output capacitance is used as a switching element. Thereby the conduction loss decreases, and the necessity for a parallel condenser is eliminated or the parallel condenser is replaced with a condenser having a smaller capacitance than the parallel condenser.

## Description

The present invention relates in general to a switching circuit. More specifically, the invention relates to a soft switching circuit that realizes the low noise and high efficiency of an electric-power converter.

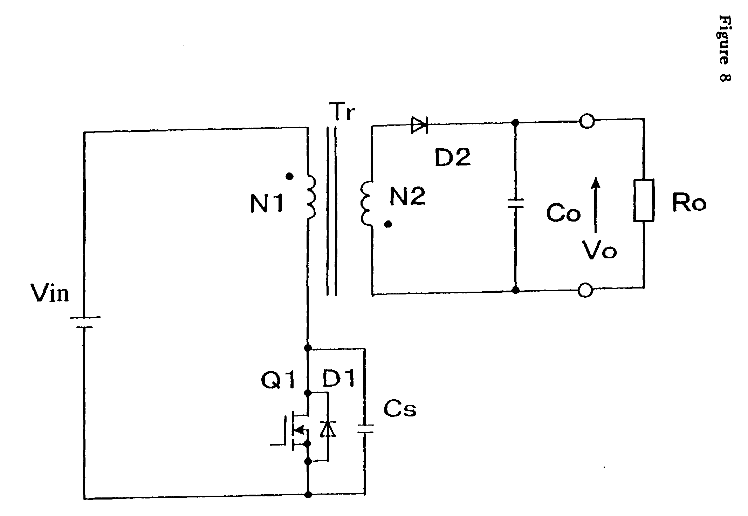

Figure 8 shows a voltage resonance circuit that is utilized in a television or other electrical equipment, in which Q1 denotes a metal oxide semiconductor field-effect transistor (MOSFET). More specifically, a primary winding N1 of a transformer Tr is connected to a DC power supply Vin via the transistor Q1. A diode D1 is connected in anti-parallel to the transistor Q1. A condenser Cs is connected in parallel to the transistor Q1. A condenser Co is connected to a primary winding N2 of the transformer Tr via a diode D2, wherein a load Ro is connected to the condenser Co. The diode D2 and the condenser Co form a rectifying and smoothing circuit. A parasitic diode of the transistor Q1 may be used as the diode D1.

A description will now be given of the operation of the voltage resonance circuit illustrated in Figure 8. While the transistor Q1 is in its on-state, an excitation energy is stored in the transformer Tr by the following route: the DC power supply Vin, the primary winding N1 of the transformer, and the transistor Q1. When the transistor Q1 is then turned off, an electric current is transferred to the condenser Cs, so that the condenser voltage can be increased from zero. When the voltage of the condenser Cs reaches the sum of an input voltage Vin and a product VoN1/n2 (where Vo is an output voltage), the energy stored in the transformer Tr is emitted to the secondary side by the following route: the secondary winding N2, the diode D2, the condenser Co. When all the energy stored in the transformer Tr has been emitted, the electric charge stored in the condenser Cs is emitted by the following route: the condenser Cs, an excitation inductance of the transformer Tr, and the DC power supply Vin. Even if the voltage of the condenser Cs becomes 0V, the electric current of the excitation inductance of the transformer Tr flows into the DC power supply Vin through the diode D1.

Transistor Q1 is turned on while the electric current is passed through the diode D1. Then, the excitation energy is stored again in the transformer Tr by the previously-described route: the DC power supply Vin, the primary winding N1 of the transformer, and the transistor Q1.

In this voltage resonance circuit, the condenser Cs connected in parallel to transistor Q1 is charged from 0V while the transistor Q1 is off. Thus, a so-called zero voltage switching (ZVS) is performed, and there is no switching loss and radiation noise. The ZVS is also performed while the transistor Q1 is on, since the transistor Q1 is turned on while the diode D1 connected in parallel to the transistor Q1 is conductive. Thus, there is no switching loss and radiation noise while the transistor Q1 is on.

The energy stored in Cs is hardly lost because it is regenerated into the power supply when it is emitted by the following route: the condenser Cs, the excitation inductance of the transformer Tr, and the DC power supply Vin. The above-mentioned voltage resonance circuit with little switching loss and radiation noise is applicable for use in a television or other electronic devices.

In the voltage resonance circuit in Figure 8, the resonance voltage of the resonance circuit, formed by the excitation inductance of the transformer Tr and the condenser Cs, is applied to the transistor Q1. For this reason, the MOSFET applied to the television or the like must have a breakdown voltage of the 1800V-class, although the DC voltage is about 120V. The increase in the ON-resistance of the MOSFET is proportional to the breakdown voltage to the power of 2.5. Thus, the MOSFET with the high breakdown voltage has such a disadvantage that there is a large conduction loss. In order to decrease the ON resistance, it is necessary to use an expensive MOSFET with large-sized chips. Moreover, the parallel condenser Cs with about several nF to several tens of nF must have a high voltage proof.

In view of the foregoing, it is an object of the present invention to simplify the switching circuit and decrease the ON resistance and the conduction loss, thereby improving the conversion efficiency and reducing the size of a heatsink.

The invention accomplishes the above object by providing a switching circuit in which a condenser is connected in parallel to a switching element to perform a resonance operation with an inductance, wherein a super-junction MOSFET is used as the switching element, and the MOSFET has a drift region that is composed of thin p-layers and n-layers alternately stacked or piled up. In one embodiment, the output capacitance of the super-junction MOSFET may be used as the parallel condenser. Thereby the necessity for the parallel condenser is eliminated, or the parallel condenser is replaced with a condenser having a smaller capacitance than the parallel condenser.

The invention will be described in detail with reference to certain preferred embodiments thereof and the accompanying drawings, wherein:
Figure 1 is a circuit diagram showing the first embodiment of the present invention;
Figure 2 illustrates a structure of the super-junction MOSFET;
Figure 3 illustrates the ON resistance of the super-junction MOSFET and the electric charge at the time of the switching;
Figure 4 illustrates the output characteristics of the super-junction MOSFET;
Figure 5 is a waveform chart showing the operation of the super-junction MOSFET when it is tuned off;
Figure 6 is a circuit diagram showing the second embodiment of the present invention;
Figure 7 is a circuit diagram showing the third embodiment of the present invention; and
Figure 8 is a circuit diagram showing an example of the conventional voltage resonance circuit.

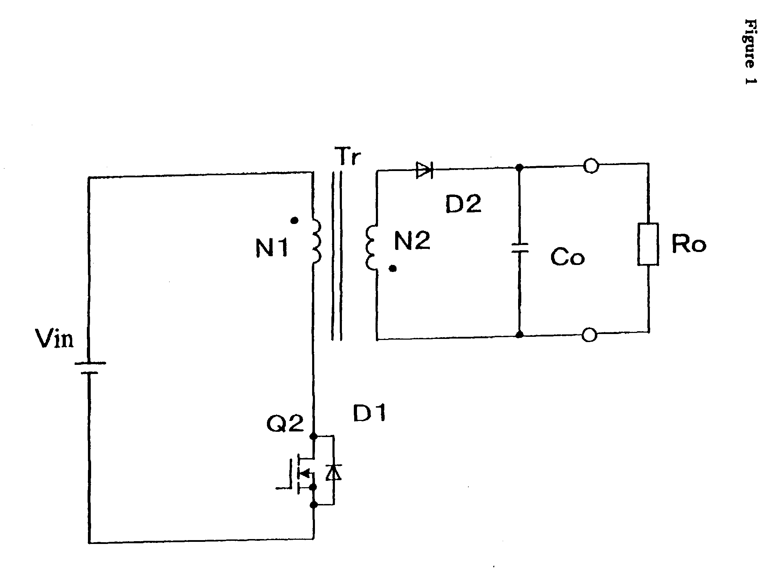

Referring now to the Figures, Figure 1 is a circuit diagram showing a first embodiment of the present invention. The circuit illustrated in Figure 1 is different from that illustrated in Figure 8, in that the transistor Q1 is replaced with a transistor Q2, which is a super-junction MOSFET (hereinafter abbreviated as a SJMOSFET), and that the condenser Cs is eliminated. The operation of the circuit in Figure 1 will not be described in great detail, since the description with reference to the operation of the circuit in Figure 8 is applicable, as would be readily understood by one of skill in the art, if the transistor Q1 is replaced with transistor Q2 and the condenser Cs is replaced with the output capacitance of transistor Q2. More specifically, if the circuit is constructed as shown in Figure 1, the ON resistance of a switching element (SJMOSFET) is lowered to reduce the conduction loss and eliminate the necessity for the condenser Cs or reduce the capacitance of the condenser Cs.

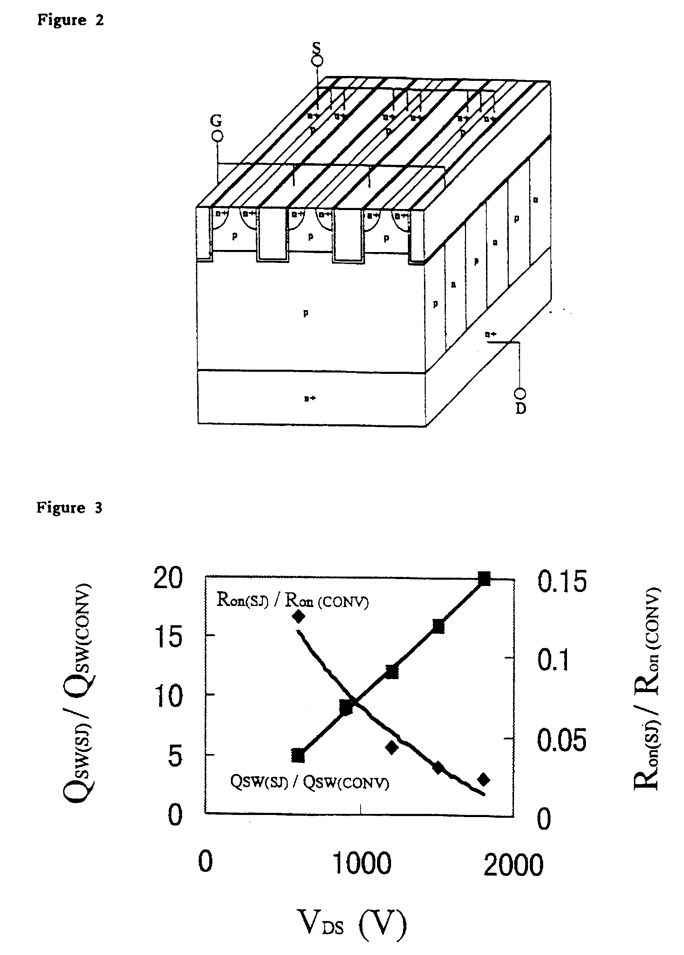

Figure 2 shows the structure of the SJMOSFET. As shown in Figure 2, a drift region is composed of thin p-layers and n-layers that are alternately stacked or piled up.

Figure 3 shows the ON resistance ratio Ron(SJ)/Ron(CONV) and the charge ratio Qon(SJ)/Qon(CONV) at the time of the switching between the SJMOSFET and the conventional MOSFET. More specifically, the higher breakdown voltage of the SJMOSFET is, the smaller the ON resistance is and the larger the quantity of electric charge is compared with the conventional MOSFET. In the case of an element of the 1800V-class, the ON resistance is decreased to about 1/40 and the quantity of electric charge is increased 20 times.

Further details of the structure and operation of the MOSFET (SJMOSFET) can be found in references such as "Jpn. J. Appl. Phys. Vol. 36 (1997), pp. 6254-6262, Part 1. No. 10. October 1997", and "Proceedings of 1998 International Symposium on Power Semiconductor Devices & ICs, Kyoto pp. 423-426", the contents of both of which are incorporated herein by reference.

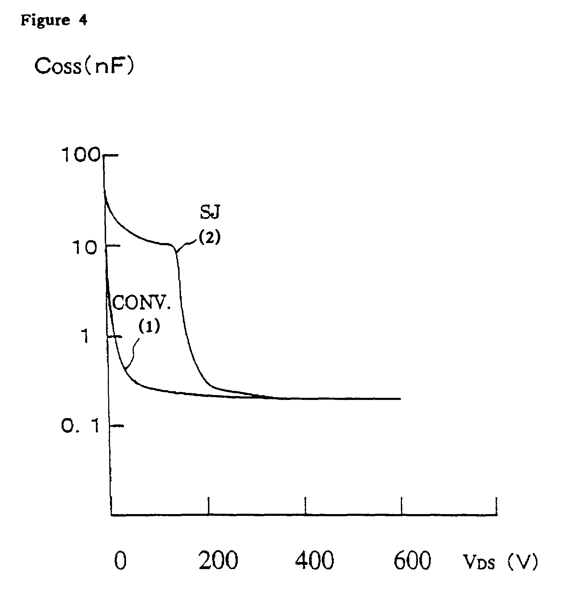

Figure 4 shows the characteristics of the output capacitance Coss with respect to the applied voltage V_{DS}. In the case of the conventional MOSFET (CONV), the output capacitance Coss is sharply decreased from approximately 10V [vid.(1)]. In the case of the SJMOSFET, the applied voltage V_{DS} is sharply decreased from about 200V [vid. (2)].

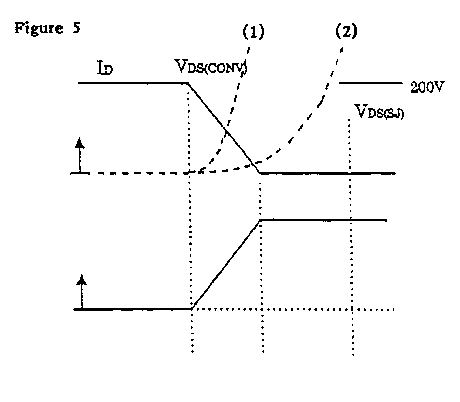

Figure 5 shows the switching operation while the SJMOSFET is off. In the conventional circuit, the parallel-connected constant capacitance Cs is charged, and thus, the voltage is sharply increased as shown in (1). On the other hand, the output capacitance Coss of the SJMOSFET is kept very large until the applied voltage V_{DS} reach about 200V. Thus, the voltage of the SJMOSFET increases more gradually than the conventional circuit as shown in (2). The switching loss while the circuit is off is represented by the product obtained by multiplying the voltage V_{DS} and the electric current Id together. Thus, the SJMOSFET reduces the switching loss compared with the conventional MOSFET.

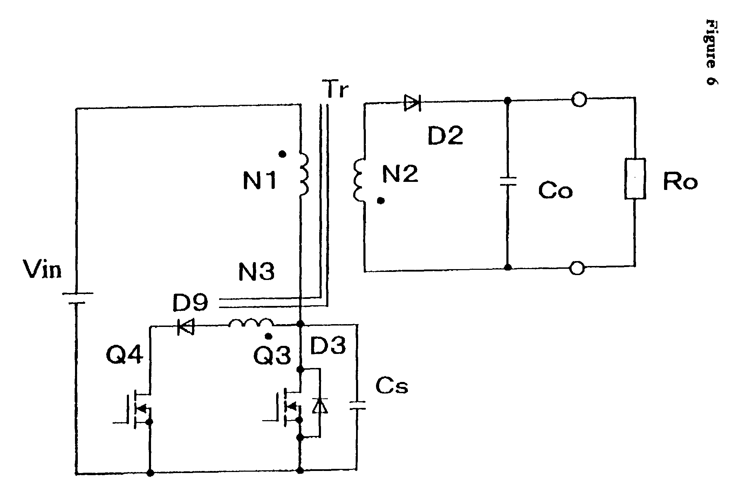

Figure 6 shows an example of a partial resonance circuit in accordance with an embodiment of the invention. A series circuit composed of a primary winding N1 of a transformer Tr and a SJMOSFET Q3 is connected to a DC power supply Vin. A diode D3 is connected in anti-parallel to the transistor Q3. A condenser Cs is connected in parallel to the transistor Q3, a series circuit composed of a tertiary winding N3 of the transformer Tr, a diode D9 and transistor (MOSFET) Q4 is connected in parallel to transistor Q3. A rectifying and smoothing circuit composed of a diode D2 and a Condenser Co is connected to the secondary winding N2 of the transformer Tr. A load Ro is connected to the condenser Co. The parasitic diode of transistor Q3 may be used as the diode D3.

In operation, the transistor Q4 is turned on to discharge the condenser Cs and the output capacitance of the transistor Q3, and then transistor Q3 is turned on under zero voltage. Thus, zero voltage switching ZVS is performed. The ZVS is also performed when transistor Q3 is turned off since the condenser Cs and the output capacitance of transistor Q3 are charged from 0V.

Thus, the use of the above-mentioned partial resonance circuit reduces the switching loss and the radiation noise. Moreover, the use of the SJMOSFET Q3 reduces the ON resistance and the conduction loss compared with the conventional MOSFET. In addition, the increase in the output capacitance results in the decrease in the capacitance of the condenser Cs.

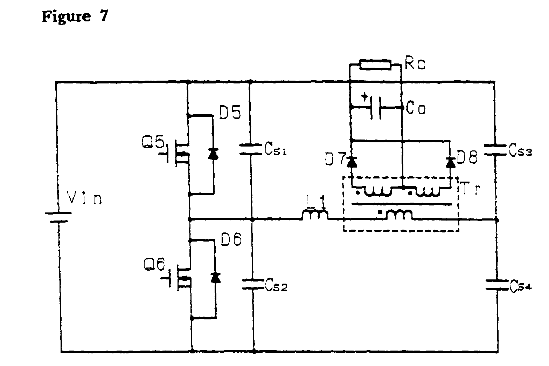

Figure 7 shows an electric current resonance/voltage resonance circuit (a composite resonance circuit) in accordance with the invention. A series circuit composed of SJMOSFETs Q5 and Q6 to a DC power supply Vin. Diodes D5 and D6 are connected in anti-parallel to SJMOSFETs Q5 and Q6, respectively. Condensers Cs1 and Cs2 are connected in parallel to SJMOSFETs Q5 and Q6, respectively. A series circuit of condensers Cs3 and Cs4 is in parallel to the series circuit of Q5 and Q6. A primary winding of transformer Tr is connected via a reactor L1 between a middle point of the series circuit Q5, Q6 and a middle point of the series circuit Cs3, Cs4. The transformer has two secondary windings to which Diodes D7 and D8 are connected, so that a fullwave rectifying circuit is formed. A smoothing condenser Co is connected to the rectifying circuit; and a load Ro is connected to the condenser Co. The composite resonance circuit can also perform the ZVS (switching) operation by turning on transistors Q5 and Q6 alternately.

A description will now be given of the operation of transistor Q5. When transistor Q5 is turned on, the condenser Cs1 is 0V, and thus, the ZVS can be performed. Transistor Q6 is turned off before transistor Q5 is turned off. Then, an electric current passed through the reactor L1 is transferred by the following route: L1, Cs1, Vin, Cs4, the primary winding of Tr. Consequently, the voltage of the condenser Cs1 becomes 0. Turning on transistor Q5 in such a state starts the ZVS operation.

In the case of the composite resonance circuit, the use of the SJMOSFETs Q5 and Q6 reduces the ON resistance and the conduction loss compared with the conventional MOSFET. Moreover, the increase in the output capacitance results in the decrease in the capacitance of the condensers Cs1 and Cs2 can be decreased.

According to the present invention, the ON conduction of the switching element in the soft switching circuit, in which the condenser is connected in parallel to the switching element, is lowered. This reduces the conduction loss and improves the conversion efficiency. Therefore, the size of the heatsink is reduced and the apparatus can be compact. In addition, there is no necessity for the condensers that are connected in parallel to the switching element, or the capacitance of such condensers is decreased. This reduces the number of parts and lowers the cost for the apparatus.

The invention has been described with reference to certain preferred embodiments thereof. It will be understood, however, that modifications and variations are possible within the scope of the appended claims. For example, a voltage resonance circuit, a partial resonance circuit and a composite resonance circuit were described above, but the present invention may also be applied to various kinds of soft switching circuits in which a condenser is connected in parallel to a switching element.

## Claims

1. A switching circuit comprising:
a condenser connected in parallel to a switching element to perform a resonance operation with an inductance;
the switching element comprising a super-junction MOSFET including a drift region that is composed of alternately stacked p-layers and n-layers.

2. A switching circuit as defined in claim 1, wherein said parallel condenser includes an output capacitance of said super-junction MOSFET.

3. A switching circuit adapted for use with an input DC power supply comprising:
a switching element comprising a super-junction MOSFET including a drift region that is composed of alternately stacked p-layers and n-layers;
a diode connected in anti-parallel with said switching element;
a condenser connected in parallel with said switching element;
a transformer having a primary winding and a secondary winding;
said primary winding is connected to said DC power supply via said switching element;
said condenser performing a resonance operation in cooperation with an excitation inductance of said transformer;
a rectifying and smoothing circuit connected to said secondary winding of the transformer; and
said switching element being turned on when the voltage of said condenser is zero.

4. A switching circuit as defined in claim 3, wherein said condenser is formed by an output capacitance of said super-junction MOSFET.
